# EUROPEAN PATENT APPLICATION

(11) **EP 4 465 537 A1**
(43) Date of publication of application: **20.11.2024**
(21) Application number: 23798318.4
(22) Date of filing: 27.06.2023
(51) Int. Cl.: H03H 9/02, H03H 9/17, H03H 9/13, H03H 3/02, H03H 9/10

(54) **RESONATOR, RESONATOR ASSEMBLY, FILTER, ELECTRONIC DEVICE, AND MANUFACTURING METHOD AND PACKAGING STRUCTURE FOR RESONATOR**

(30) Priority: 06.04.2023 CN 202310402705
(71) Applicant: JWL (Zhejiang) Semiconductor Co., Ltd., Huzhou, Zhejiang 313000 (CN)
(72) Inventor: LI, Linping, Huzhou, Zhejiang 313000 (CN)
(74) Representative: Kolster Oy Ab
(86) International application number: PCT/CN2023/102702
(87) International publication number: WO 2024/207626

(57) **Abstract**

A resonator, a resonator assembly, a filter, an electronic device, a method for fabricating the resonator, and a packaging structure are provided. The bulk acoustic resonator includes a substrate, a first electrode, a second electrode, an acoustic reflection structure between the first electrode and the substrate, and a piezoelectric layer arranged between the second electrode and the first electrode. In a direction perpendicular to the substrate, an overlapping region of the acoustic reflection structure, the first electrode, the piezoelectric layer and the second electrode is an active region that is annular. A distance from a point A on an inner edge of the active region to a center of the resonator is D, and a shortest distance from A to an outer edge of the active region is W, where 0.1≤W/D≤10. The heat dissipation rate of the resonator can be improved by modifying W.

## Description

This application claims the priority to Chinese Patent Application No. 202310402705.5, titled "RESONATOR, RESONATOR ASSEMBLY, FILTER, ELECTRONIC DEVICE, METHOD FOR FABRICATING RESONATOR AND PACKAGING STRUCTURE", filed on April 06, 2023 with the China National Intellectual Property Administration, which is incorporated herein by reference in its entirety.

### FIELD

The present disclosure relates to the technical field of semiconductors, and in particular to a resonator, a resonator assembly, a filter, an electronic device, a method for fabricating the resonator, and a packaging structure for the resonator.

### BACKGROUND

Currently, main functional layers, e.g., a piezoelectric layer and an electrode, of a resonator are only microns or nanometers in thickness. As a result, heat is easily accumulated in the functional layers, which brings some negative effects, such as a frequency drift of the resonator; or causes or accelerates the aging and damage of the functional layers, affecting the reliability and an operating lifetime of the resonator, and further limiting the increase of a power capacity of the resonator. Therefore, how to improve the heat dissipation capability of the resonator is a technical problem to be solved.

### SUMMARY

In view of this, a bulk acoustic resonator is provided according to a first aspect of the present disclosure. The bulk acoustic resonator includes: a substrate, a first electrode, a second electrode, an acoustic reflection structure and a piezoelectric layer. The acoustic reflection structure is arranged between the first electrode and the substrate. The piezoelectric layer is arranged between the second electrode and the first electrode. In a direction perpendicular to the substrate, an overlapping region of the acoustic reflection structure, the first electrode, the piezoelectric layer and the second electrode is an active region, and the active region is annular. A distance from a point A on an inner edge of the active region to a center of the resonator is D, and a shortest distance from the point A to an outer edge of the active region is W, where 0.1≤W/D≤10.

In an embodiment, in the bulk acoustic resonator, an inactive region is arranged inside the inner edge of the active region, the active region is S1 in area, and the inactive region is S2 in area, where S1 and S2 meet an equation of 0.2≤S1/S2≤12.

In an embodiment, in the bulk acoustic resonator, shortest distances from multiple points A to the outer edge of the active region are multiple distances W, the multiple distances W include a maximum and a minimum, and a ratio of the maximum to the minimum is 1.5:1.

In an embodiment, in the bulk acoustic resonator, each of the distances W ranges from 10µm to 50µm.

In an embodiment, in the bulk acoustic resonator, in the direction perpendicular to the substrate, at least one of the acoustic reflection structure, the piezoelectric layer, the first electrode, and the second electrode is annular, to form the active region that is annular.

In an embodiment, in the bulk acoustic resonator, the acoustic reflection structure is arranged on an upper surface of the substrate or embedded inside the substrate.

In an embodiment, in the bulk acoustic resonator, the acoustic reflection structure ranges from 0.1µm to 0.5µm in height.

In an embodiment, in the bulk acoustic resonator, the acoustic reflection structure is provided with a dielectric block in a central region of the acoustic reflection structure, the dielectric block is arranged in the inactive region, and the acoustic reflection structure forms an annular structure based on the dielectric block.

In an embodiment, in the bulk acoustic resonator, the dielectric block is in a hollow structure, a first release channel is defined on a bottom of the hollow structure, and the first release channel passes through the bottom of the hollow structure in the direction parallel to the substrate.

In an embodiment, in the bulk acoustic resonator, the dielectric block is in a solid structure, a second release channel is defined on a side wall of the solid structure, and the second release channel passes through the solid structure in the direction perpendicular to the substrate.

In an embodiment, in the bulk acoustic resonator, in the direction perpendicular to the substrate, a gap is provided between the piezoelectric layer and the second electrode, and/or a gap is formed between the substrate and the first electrode, and the gap is located in the inactive region.

In an embodiment, in the bulk acoustic resonator, at least one of an upper surface of the first electrode and an upper surface of the piezoelectric layer is provided with a first recessed part, and a first gap is formed between at least one of the first recessed part and the second electrode.

In an embodiment, in the bulk acoustic resonator, the first electrode is recessed downwards or the first electrode and the piezoelectric layer are recessed downwards, to form a second recessed part, and a second gap is formed between at least one of the second recessed part and the second electrode.

A resonator assembly is provided according to a second aspect of the present disclosure. The resonator assembly includes any one bulk acoustic resonator described above. The bulk acoustic resonator is electrically connected to at least one electrical structure, and the at least one electrical structure is arranged in an inactive region.

A packaging structure for the bulk acoustic resonator described above is provided according to a third aspect of the present disclosure. A packaging film is arranged above the resonator, the packaging film seals the active region, and the packaging film is acoustically isolated from the active region.

In an embodiment, in the packaging structure, the packaging film is directly connected to the inactive region, or a support part is provided between the packaging film and the inactive region.

In an embodiment, in the packaging structure, the support part includes a metal column, a bottom of the metal column is electrically connected to the first electrode or the second electrode, and a top of the metal column is exposed for electrical connection.

A filter is provided according to a fourth aspect of the present disclosure. The filter includes the resonator described above.

An electronic device is further provided according to a fifth aspect of the present disclosure. The electronic device includes the resonator described above.

A method for fabricating a bulk acoustic resonator is further provided according to a sixth aspect of the present disclosure. The method includes:
providing a substrate;
forming an acoustic reflection structure on the substrate;
forming a first electrode, a piezoelectric layer, and a second electrode sequentially on the substrate and the acoustic reflection structure; where
in a direction perpendicular to the substrate, an overlapping region of the acoustic reflection structure, the first electrode, the piezoelectric layer and the second electrode is an active region, and the active region is annular;
a distance from a point A on an inner edge of the active region to a center of the resonator is D, and a shortest distance from the point A to an outer edge of the active region is W, where 0.1≤W/D≤10.

Compared with the conventional technology, the present disclosure has the following beneficial effects.

The bulk acoustic resonator has the annular active region, and therefore performs excellently in heat dissipation, so that the resonator can basically remain at a constant temperature during operation. A distance from a point A on an inner edge of the active region A to a center point of the resonator is D. The shortest distance from the point A to an outer edge of the active region A is W. The distance W is modified based on a resonance frequency and a power tolerance for the resonator under condition of 0.1≤W/D≤10, to maximize the heat dissipation. Therefore, the resonator still performs excellently in heat dissipation even at

### BRIEF DESCRIPTION OF THE DRAWINGS

In order to more clearly illustrate technical solutions in embodiments of the present disclosure or in the conventional technology, the drawings to be used in the description of the embodiments or the conventional technology are briefly described below. Apparently, the drawings in the following description show only some embodiments of the present disclosure, and other drawings may be obtained by those skilled in the art from the drawings without any creative work.

The structure, scale, and size shown in the drawings of this specification are only used for cooperation with the contents disclosed in the specification for those skilled in the art to understand and read, instead of limiting the conditions under which the present disclosure can be implemented, and thus have no technically substantive significance. Any structural modifications, changes in scale, or adjustments in size without affecting effectiveness and purpose of the present disclosure should fall within the scope of the technical contents disclosed in the present disclosure.
Figure 1 is a schematic structural diagram of an air-gap type resonator;
Figure 2 is a cross-sectional view of a bulk acoustic resonator according to an embodiment of the present disclosure;
Figure 3 is a top view of the bulk acoustic resonator illustrated in Figure 2;
Figure 4 illustrates a thermodynamic simulation result of a conventional resonator in a sandwich structure;
Figure 5 illustrates a thermodynamic simulation result of a resonator according to another embodiment of the present disclosure;
Figure 6 illustrates a thermodynamic simulation result of another conventional resonator in a sandwich structure;
Figure 7 illustrates a thermodynamic simulation result of a resonator according to another embodiment of the present disclosure;
Figure 8 is a top view of an acoustic reflection structure of a resonator according to another embodiment of the present disclosure;
Figure 9 is a cross-sectional view of a resonator according to another embodiment of the present disclosure;
Figure 10 is a cross-sectional view of a resonator according to another embodiment of the present disclosure;
Figure 11 is a top view of an acoustic reflection structure of a resonator according to another embodiment of the present disclosure;
Figure 12 is a cross-sectional view of the acoustic reflection structure illustrated in Figure 11 along a VV' direction;
Figure 13 is a top view of an acoustic reflection structure of a resonator according to another embodiment of the present disclosure;
Figure 14 is a cross-sectional view of the resonator illustrated in Figure 13 along an BB' direction;
Figure 15 is a cross-sectional view of a resonator according to another embodiment of the present disclosure;
Figure 16 is a cross-sectional view of a resonator according to another embodiment of the present disclosure;
Figure 17 is a cross-sectional view of a resonator according to another embodiment of the present disclosure;
Figure 18 is a cross-sectional view of a resonator according to another embodiment of the present disclosure;
Figure 19 is a top view of a resonator assembly according to an embodiment of the present disclosure;
Figure 20 is a cross-sectional view of the resonator assembly illustrated in Figure 19 along a CC' direction;
Figure 21 is a cross-sectional view of a packaging structure for a resonator according to an embodiment of the present disclosure; and
Figure 22 is a cross-sectional view of a packaging structure for a resonator according to another embodiment of the present disclosure.

### DETAILED DESCRIPTION

The embodiments of the present disclosure are described clearly and completely hereinafter with reference to the drawings in the embodiments of the present disclosure. Apparently, the described embodiments are some rather than all of the embodiments of the present disclosure. All of other embodiments obtained by those skilled in the art based on the embodiments in the present disclosure without any creative work fall within the protection scope of the present disclosure.

A film bulk acoustic resonator (Fbar) has excellent characteristics of small size, high resonant frequency, high quality factor and large power capacity, and thus plays a crucial role in the communication field.

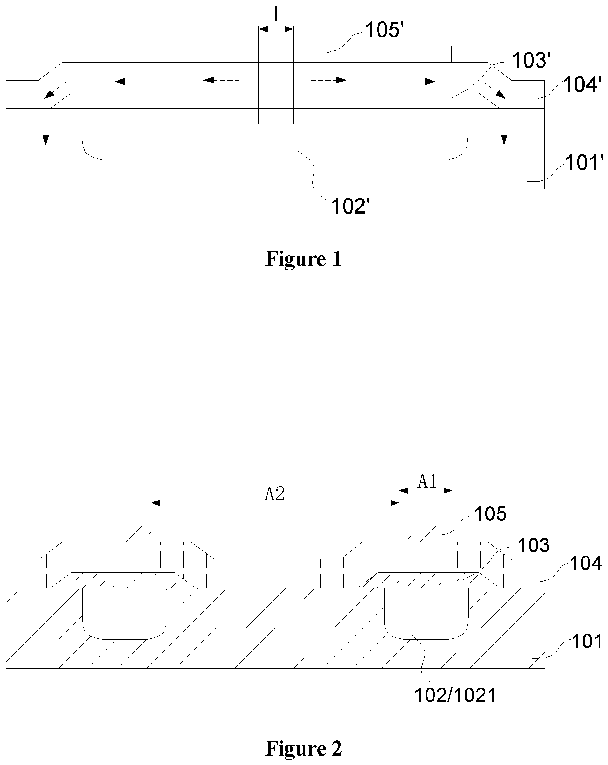

Figure 1 is a schematic structural diagram of an air-gap type resonator. The resonator shown in Figure 1 includes a substrate 101', an acoustic reflection structure 102', a first electrode 103', a second electrode 105', and a piezoelectric layer 104' arranged between the first electrode 103' and the second electrode 105'. The first electrode 103' and the second electrode 105' each are also known as an excitation electrode, for driving the piezoelectric layer 104' to vibrate. The acoustic reflection structure 102' is arranged between the first electrode 103' and the substrate 101', so that the first electrode 103' is acoustically isolated from the substrate 101', to prevent energy loss resulted from an acoustic wave being transmitted to the outside of the resonator.

As shown in Figure 1, the resonator involves only conversion between mechanical energy and electrical energy ideally. In practice, part of electrical energy and a bulk acoustic wave in the resonator is inevitably converted into thermal energy, and the resonator of higher power heats up significantly. Dashed arrows illustrated in Figure 1 represent heat transfer paths. As air conducts heat poorly, heat in the resonator is transferred to a part of the substrate 101' through the electrodes and the piezoelectric layer 104' mainly, and thence to the entire substrate 101' for heat dissipation. A center region I of the resonator is far away from the substrate 101'. As a result, the heat is easily accumulated in the center region I, affecting the performance of the resonator. Therefore, how to improve the heat dissipation of the resonator is a technical problem to be solved.

In view of the above problem, a resonator, a resonator assembly, a filter, an electronic device, a method for fabricating the resonator, and a packaging structure for the resonator are provided according to the present disclosure. The resonator has an annular active region, and therefore performs excellently in heat dissipation, so that the resonator can basically remain at a constant temperature during operation. A distance from a point A on an inner edge of the active region to a center point of the resonator is D. The shortest distance from the point A to an outer edge of the active region is W. The distance W is modified based on a resonance frequency and a power tolerance for the resonator under condition of 0.1≤W/D≤10, to improve the heat dissipation.

The present disclosure is further described in detail below in conjunction with the drawings and specific embodiments so that the above objects, features, and advantages of the present disclosure are more understandable.

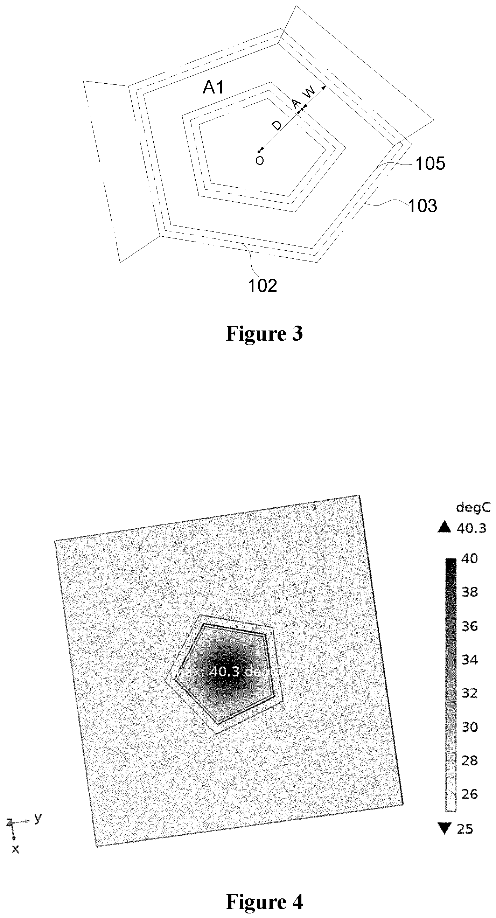

Figure 2 is a cross-sectional view of a bulk acoustic resonator according to an embodiment of the present disclosure. Figure 3 is a top view of the bulk acoustic resonator illustrated in Figure 2. As shown in Figures 2 and 3, the resonator according to the embodiments includes: a substrate 101, a first electrode 103, a piezoelectric layer 104, a second electrode 105, and an acoustic reflection structure 102. The resonator is provided with an active region A1 in a direction perpendicular to the substrate 101. An overlapping region of the acoustic reflection structure 102, the first electrode 103, the piezoelectric layer 104 and the second electrode 105 serves as the active region A1. A distance from a point A on an inner edge of the active region A1 to a center point O of the resonator is D. The shortest distance from the point A to an outer edge (away from the center point) of the active region A1 is W, where 0.1≤W/D≤10. The acoustic reflection structure 102 is a cavity 1021 or a Bragg reflection layer. In this embodiment, the acoustic reflection structure 102 is the cavity 1021, for example. In some embodiments, the resonator is cross sectioned in a direction parallel to the substrate 101, and the point A and the center point O are determined on the cross-sectional view. The inner edge of the active region A1 is the same as or different from the outer edge of the active region A1 in shape. The shape includes but is not limited to a circle, an oval, a regular polygon with each angle greater than 90°, an irregular polygon with each angle greater than 90° or a special shape. In some preferred embodiments, the active region that is annular is the irregular polygon with each angle greater than 90°, and the inner edge is the same as the outer edge in shape, which can effectively reduce the leakage of the acoustic wave, thereby increasing parallel resonance frequency (Rp). In this embodiment, the active region A1 is an approximately five-sided ring, for example. The distance W between the inner edge and the outer edge of the active region A1 thar are opposite and parallel is constant. The center point O depends on the inner edge of the active region A1, for example, is a geometric center of the inner edge, determined by means of commonly used computer software such as AUTO CAD or calculated with calculus by establishing coordinates. If the electrodes of the resonator are formed by irregular pentagons through chamfering, the geometric center is determined based on the irregular pentagons before the chamfering.

In actual production and design, the distance W may be calculated based on a point in a central region of a region surrounded by the active region A1, where the central region is relatively small in area.

The resonator has the active region A1 that is annular, and therefore basically remains at a constant temperature and has excellent heat dissipation during operation. Similar to the conventional technology, the resonator transfers heat from the inside of the active resonance region to the edges of the active resonance region for heat dissipation. According to the embodiments of the present disclosure, the path for the heat being transferred from a location of 1/2W (where heat is accumulated) to a region outside the inner edge or the outer edge is shortened due to the short distance W from the inner edge of the active region A1 to the outer edge of the active region A1. Therefore, a large amount of heat can be dissipated rapidly instead of accumulated in the active resonance region, thereby improving the performance of the resonator.

According to the embodiments of the present disclosure, the active region A1 in the resonator is annular to improve the heat dissipation, which is more significant especially for low to middle frequency resonators and high-frequency resonators.

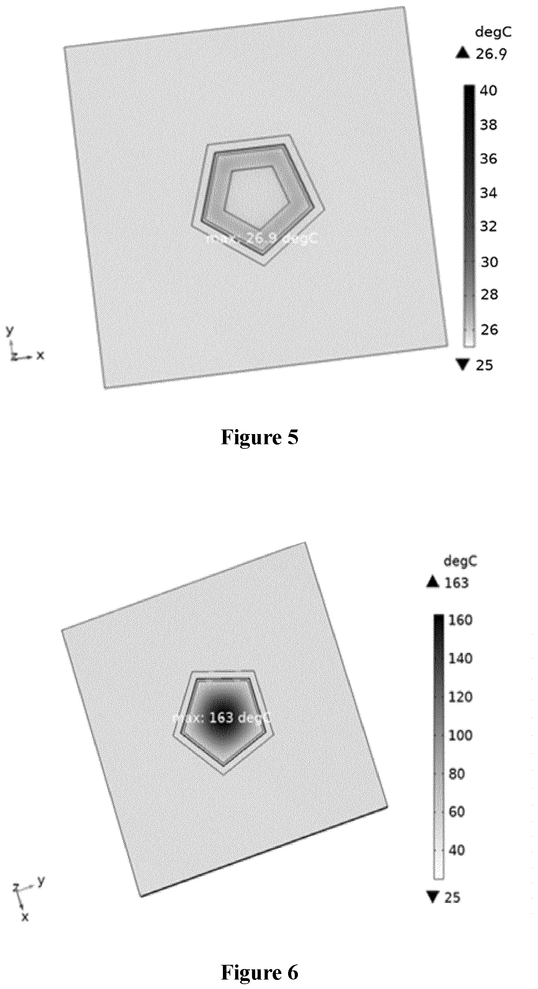

Figure 4 illustrates a thermodynamic simulation result of a conventional resonator in a sandwich structure. Figure 5 illustrates a thermodynamic simulation result of a resonator according to embodiments of the present disclosure. The conventional resonator in the sandwich structure and the resonator according to the embodiment of the present disclosure are equal in effective area and frequency (e.g., low to middle frequency of 2.5GHz). The heat in the conventional resonator in the sandwich structure as shown in Figure 4 is distributed unevenly. That is, the heat accumulates towards the center, at a highest temperature of 40.3°C. By comparison, the heat is the resonator according to the embodiments of the present disclosure as shown in Figure 5 is distributed evenly, at the highest temperature of 26.9°C merely with a difference of 13.4°C. Therefore, the resonator according to the embodiments of the present disclosure performs better than the conventional resonator in the sandwich structure in heat dissipation.

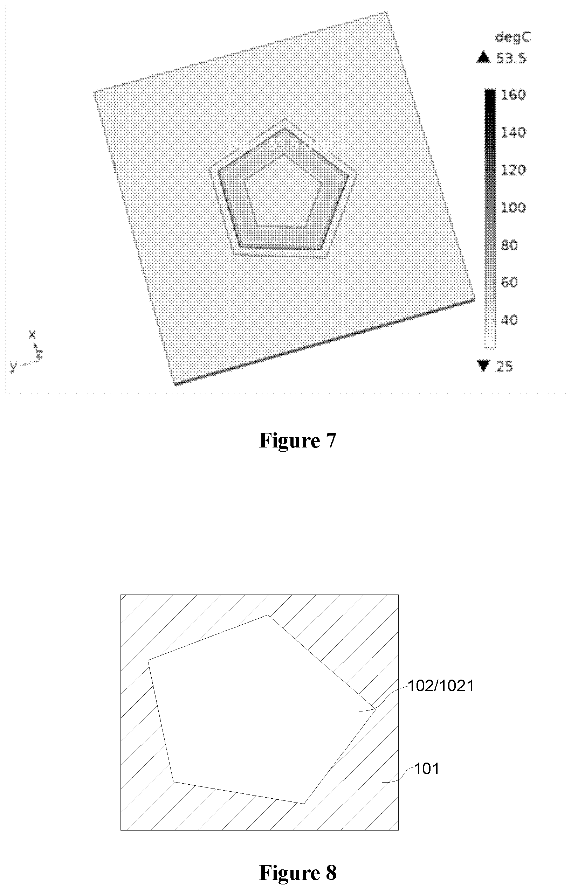

Figure 6 illustrates a thermodynamic simulation result of another conventional resonator in a sandwich structure. Figure 7 illustrates a thermodynamic simulation result of a resonator according to embodiments of the present disclosure. The conventional resonator in the sandwich structure and the resonator according to the embodiments of the present are equal in effective area and frequency (e.g., a high frequency of 6GHz). The center of the conventional resonator in the sandwich structure shown in Figure 6 reaches the highest temperature of 163°C. The resonator according to the embodiments of the present disclosure shown in Figure 7 reaches the highest temperature of 53.5°C only, and the heat is distributed relatively evenly at the high frequency without significant heat accumulation. The functional layers are thinner and thus performs poorly in heat dissipation when operating at high frequency. Therefore, the temperature significantly changes, decreasing from 163°C to 53.5°C, with a difference of 109.5°C. The functional layers include the piezoelectric layer 104, the first electrode 103 and the second electrode 105.

According to the embodiments of the present disclosure, the resonator performs excellently in heat dissipation. Especially, the high-frequency resonator in such structure may operate at room temperature or slightly high temperature for a long time, thereby prolongating an operating lifetime of the resonator. In addition, the active region of the resonator is annular, and therefore is more flexible in area. When a single resonator in the conventional structure that is large in area operates at high frequency, the first electrode 103, the second electrode 105 and the piezoelectric layer 104 that are thin are prone to deformation resulted from stress which reduces the reliability of the resonator at high or low temperature, resulting in a failure of the resonator. The resonator that is annular has a short distance W from its inner edge to outer edge, and therefore has better mechanical support and performs excellently in heat dissipation. Further, the active region of the resonator is flexible in area.

Based on the resonator according to the above embodiments, it can be seen that in the direction parallel to the substrate 101, the distance from the inner edge to the outer edge of the active region A1 is W, the distance from the center O of the resonator to the inner edge of the active region A1 is D, and the distance W and the distance D have the relationship of 0.1≤W/D≤10. The resonator with W/D ranging from 0.1 to 10 performs excellently in heat dissipation. W/D is negatively correlated with a heat dissipation rate for the resonator. A small W/D indicates a small distance from a heat concentration region in the active region A1 to the edge of the active region A1, and further a high heat dissipation rate. The resonance frequency is positively correlated with the heat dissipation rate. That is, a high frequency indicates that the resonator generates a large amount of heat and accordingly a high heat dissipation rate is desired, and W/D is small. The low to middle frequency resonators and high-frequency resonators can also perform excellently in heat dissipation by modifying W/D. That is, W/D decreases as the resonance frequency increases. For example, W/D ranging from 1 to 10 for low to middle frequency, i.e., 0 to 3GHz indicates excellent heat dissipation, and W/D ranging from 0.1 to 1 for high and ultra-high frequency, i.e., 3GHz to 7GHz and even frequency more than 7GHz indicates excellent heat dissipation effect. For a common frequency intersection ranging from 2.5GHz to 3GHz of a surface acoustic wave resonator and the bulk acoustic resonator, W/D preferably ranges from 0.8 to 2.

In addition, in a case that the frequency is constant, the heat dissipation rate for the resonator is positively correlated with power tolerance. That is, high power tolerance indicates that the resonator generates a large amount of heat and accordingly a high heat dissipation rate is desired. In such case, W/D is set to be small to facilitate the heat dissipation. For example, W/D is set to 5 for the power tolerance being generally 30dBm at 1.8GHz, for excellent heat dissipation. W/D is set to 3 for a product with the power tolerance of 32dBm at 1.8GHz. The annular resonator may be designed with the W/D of 0.5 for a product at frequency of 5GHz, and W/D may be appropriately set to 0.3 for another power tolerance.

In some embodiments, an inactive region A2 is arranged inside the inner edge of the active region A1. That is, the annular active region A1 surrounds the inactive region A2. An area of the active region A1 is defined as S1, and an area of the inactive region A2 is defined as S2. S1 and S2 meet the following equation of 0.2≤S1/S2≤12.

The heat dissipation rate of the resonator may be optimized based on the area S1 of the active region A1 and the area S2 of the inactive region A2. S1/S2 is negatively correlated with the heat dissipation rate. A small S1/S2 indicates a small distance from the heat concentration region of the active region A1 to the edge of the active region A1, and accordingly a high heat dissipation rate is desired.

In some embodiments, in the direction perpendicular to the substrate 101, at least one of the acoustic reflection structure 102, the piezoelectric layer 104, the first electrode 103, and the second electrode 105 is annular and surrounds the inactive region A2, thereby forming the annular active region. The overlapping region of the acoustic reflection structure 102, the piezoelectric layer 104, the first electrode 103, and the second electrode 105 is the active region A1, and the active region A1 is annular. Moreover, the active region A1 surrounds the inactive region A2. Preferably, the acoustic reflection structure 102 is annular, the piezoelectric layer 104 is film-shaped, and the first electrode 103 and the second electrode 105 are annular. The acoustic reflection structure 102, the piezoelectric layer 104, the first electrode 103 and the second electrode 105 may further be in other shapes, which are not limited herein. Moreover, when a radio frequency signal is transmitted, the contact area between the first electrode 103 and a medium, e.g., the substrate 101 is large, indicating heavy dielectric loss. In a case that the first electrode 103 is largely arranged in the inactive region A2, the dielectric loss of the signal is severe or demands for the substrate 101 with high impedance is increased, resulting in high cost. Therefore, a part of the first electrode 103 arranged inside the inner edge of the active region A1 (that is, the inactive region A2) may be removed through etching to form the annular first electrode 103, reducing the contact area between the first electrode 103 and the substrate 101, thereby reducing the dielectric loss and improving the Q value of the resonator. In a case that the acoustic reflection structure 102 in the resonator is annular, the first electrode 103 covers the annular acoustic reflection structure 102, and the second electrode 105 is arranged in a region surrounded by an outer edge of the acoustic reflection structure 102. The annular first electrode 103 and the annular second electrode 105 correspond to the annular acoustic reflection structure 102 in the direction perpendicular to the substrate 101. The substrate 101 and the first electrode 103 may further have a support function. In a case that the acoustic reflection structure 102 is the cavity 1021, the first electrode 103 covers the cavity 1021 completely and the second electrode 105 is arranged within an orthographic projection of the acoustic reflection structure 102, in order to reduce parasitic capacitance.

In some embodiments, the ratio of the shortest distance W from the inner edge of the active region A1 to the outer edge of the active region A1 to the distance D from the center O of the resonator to the inner edge is negatively correlated with the heat dissipation rate for the resonator. A small W/D indicates a small distance from the heat concentration region of the active region A1 to the edge of the active region A1, and a high heat dissipation rate. In some embodiments, the shortest distance W may be constant or variable at different positions of the active region A1. The shortest distances W from multiple points A to the outer edge of the active region A1 include a maximum and a minimum, and a ratio of the maximum to the minimum is 1.5:1. The maximum and the minimum are of the same active region A1. The ratio of the maximum to the minimum is set to 1.5:1, so that the annular active region A1 is even in width, thereby increasing the heat dissipation rate of the resonator.

In some embodiments, the distance W in the active region A1 ranges from 10µm to 50µm. Preferably, the distance W in the active region A1 ranges from 20µm to 30µm. The distance D from the center O of the resonator to the inner edge varies in a wide range, preferably, from 10µm to 50µm.

The acoustic reflection structure 102 is arranged on an upper surface of the substrate 101 or embedded inside the substrate 101.

Figure 8 is a top view of an acoustic reflection structure of the resonator according to another embodiment of the present disclosure. As shown in Figure 8, the embodiment of the present disclosure is described with an example that the acoustic reflection structure 102 is embedded inside the substrate 101, that is, the acoustic reflection structure 102 is an underground cavity. In the resonator according to the embodiment, the cavity 1021 in the resonator is a groove that is defined on the surface of the substrate 101, and is a single polygonal cavity. In the top view of the acoustic reflection structure, the cavity 1021 may be, but is not limited to, circular, elliptical, a regular polygon with each angle greater than 90°, an irregular polygon with each angle greater than 90° or a special shape in top view. Alternatively, the cavity is an annular cavity. In such case, an edge of the first electrode 103 is in contact with the substrate 101 for supporting and cooling the resonator.

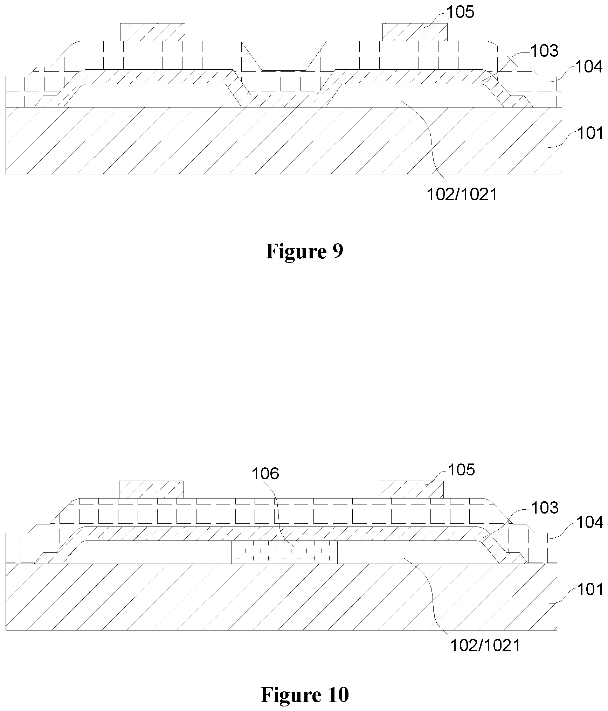

Figure 9 is a cross-sectional view of a resonator according to another embodiment of the present disclosure. As shown in Figure 9, the embodiment of the present disclosure is described with an example that the acoustic reflection structure 102 is arranged on the upper surface of the substrate 101, that is, the acoustic reflection structure 102 is an aboveground cavity. The first electrode 103 of the resonator includes a protrusion, and the aboveground cavity is formed between the protrusion and the surface of the substrate 101. For forming the aboveground cavity, the first electrode 103 only protrudes upwards and forms the cavity 1021 together with the substrate 101, without etching the substrate 101.

In some embodiments, the acoustic reflection structure 102 ranges from 0.1µm to 0.5µm in height.

In a case that the acoustic reflection structure 102 is the cavity 1021, the cavity 1021 generally ranges from 0.5µm to 2µm in height, to prevent the first electrode 103 and other film layers above the substrate 101 from adhering to the substrate 101 when the resonator resonates. In the embodiment, the active region A1 is such designed that the distance W is small, e.g., 20µm, when the resonator reaches the desired area. Compared with the conventional sandwich structure, the deformation of the film layers is greatly reduced under a same force, which indicates that stress bearable by the resonator withstands increases, thus greatly improving the reliability of the film layers. In such case, the height of the cavity 1021 may be reduced to be in a range of 0.1µm to 0.5µm, and the heat dissipation path is further shortened, thereby further improving performance of the heat dissipation of the resonator.

As the height of the cavity 1021 embedded inside the substrate 101 increases, for example, greater than 0.5µm, the height of the substrate 101 also increases, and the heat transfer path of the resonator from the upper surface of the substrate 101 to the lower surface of the substrate 101 is lengthened. As a result, heat is easily accumulated in a longitudinal direction of the substrate 101, which is not conducive to heat dissipation. In a case that the height of the cavity 1021 is less than 0.1µm, the film layers of the resonator adhere to the substrate 101. In the embodiment, the height of the cavity 1021 is set to be in a range of 0.1µm and 0.5µm. Compared with the conventional cavity 1021, the height of the substrate 101 decreases as the height of the cavity 1021 decreases, and the heat transfer path in the longitudinal direction of the substrate 101 is shortened, so that the heat transfers along a bottom of the cavity 1021, that is, along a transverse direction of the substrate 101. Therefore, the reduction of the height of the cavity 1021 leads the heat to dissipate along the bottom of the substrate 101 instead of both sides of the substrate 101, greatly improving the performance of heat dissipation. Moreover, as the height of the cavity 1021 is reduced, deposition cost of the sacrificial layers is reduced, and the heat dissipation can be sped up.

In the above embodiment, the acoustic reflection structure 102 is the Bragg reflection layer. The Bragg reflection layer is in directly contact with the functional layers, and thus a thin Bragg reflection layer leads to low thermal resistance between the functional layers and the lower surface of the substrate. Therefore, the height of the acoustic reflection structure 102 is reduced to be in the range of 0.1µm to 0.5µm, so that the heat dissipation path can be shortened, improving the performance of heat dissipation and reducing the cost of fabricating the Bragg reflector layer.

Figure 10 is a cross-sectional view of a resonator according to another embodiment of the present disclosure. As shown in Figure 10, in another embodiment of the present disclosure, the acoustic reflection structure 102 is provided with a dielectric block 106 in the central region of the acoustic reflection structure 102. The dielectric block 106 is arranged in the inactive region A2, and the acoustic reflection structure 102 is annular based on the dielectric block 106.

The embodiment is described with an example that the acoustic reflection structure 102 of the resonator is the cavity 1021, and the cavity 1021 is arranged above the substrate 101 and is provided with the dielectric block 106 inside, so that the cavity 1021 is annular and surrounds the dielectric block 106. The first electrode 103 and the piezoelectric layer 104 are both film-shaped, and the second electrode 105 is annular and surrounds the dielectric block 106. The dielectric block 106 is arranged below the first electrode 103 and in contact with the first electrode 103, and support the first electrode 103 and the functional layers above the first electrode 103, to prevent the functional layers from being deformed or collapsing. In an embodiment, the dielectric block 106 may be made of silicon dioxide (SiO₂), silicon nitride (Si₃N₄), amorphous silicon (a-Si), polycrystalline silicon (p-Si), aluminum nitride (AIN), aluminum oxide (Al₂O₃), magnesium oxide (MgO), zirconia (ZrO₂), lead zirconate titanate (PZT), gallium arsenide (GaAs), hafnium oxide (HfO₂), titanium oxide (TiO₂), or zinc oxide (ZnO).

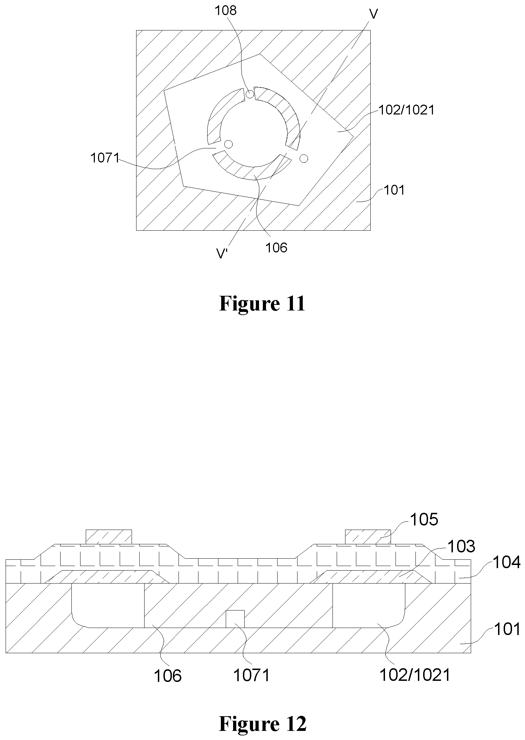

Figure 11 is a top view of an acoustic reflection structure of a resonator according to another embodiment of the present disclosure. As shown in Figure 11, the dielectric block 106 includes a hollow structure, and a first release channel 1071 is defined on a bottom of the hollow structure. In the direction parallel to the substrate 101, the first release channel 1071 passes through the bottom of the hollow structure.

The dielectric block 106 may be made of the same material as or a material different from the substrate 101. In a case that the dielectric block 106 is made of the same material as the substrate 101, the dielectric block 106 may be formed integrally with the substrate 101 or separately from the substrate 101. Specifically, a part of the substrate 101 where the dielectric block 106 is located may be retained for forming the dielectric block 106 integrally with the substrate 101 when forming the annular cavity 1021. Alternatively, the cavity 1021 is first formed, and then the dielectric block 106 that is made of the same material as the substrate 101 is formed in the central of the cavity 1021.

In other embodiments, the cavity 1021 is arranged above the surface of the substrate 101, which is also applicable to the dielectric block 106.

Figure 12 is a cross-sectional view of the acoustic reflection structure illustrated in Figure 11 along a VV' direction. The embodiment is described with an example that the acoustic reflection structure 102 is the cavity 1021, and the cavity 1021 is embedded inside the substrate 101. The dielectric block 106 is hollow inside. It can be seen from the cross-sectional view 12 that the dielectric block 106 is a hollow cylinder, and is arranged inside the cavity 1021, and both an inner space and an outer space of the dielectric block 106 are filled with air. In other words, the cavity 1021 is formed by nesting a circular cavity and an annular cavity. In order to simplify the processes of fabricating the inner space and the outer space of the dielectric block 106, for example, fabricate the inside space and the outside space of the dielectric block 106 in a one-step process, a part of the dielectric block 106 is removed from the inside of the dielectric block 106 in the direction parallel to the substrate 101 to form the first release channel 1071. Preferably, the first release channel 1071 is defined on the bottom of the dielectric block 106. In the direction parallel to the substrate 101, the first release channel 1071 horizontally passes through the dielectric block 106, so that the inner space of the dielectric block 106 is in communication with the outer space of the dielectric block 106. Furthermore, in the direction perpendicular to the substrate 101, the inner space of the dielectric block 106, the outer space of the dielectric block 106 and the functional layers above the dielectric block 106 each are provided with a release hole 108, to release the sacrificial layer in the spaces. The processes of fabricating the above spaces (including the cavity 1021 and the inner space of the dielectric block 106) includes that a to-be-formed space is first filled with a sacrificial layer material, and then a corrosion solution for reacting with the sacrificial layer material enters a position where the sacrificial layer material is located through the release hole 108 and the first release channel 1071 and reacts with the sacrificial layer material, to remove the sacrificial layer, thereby forming the space.

In addition, the first release channel 1071 not only passes through the bottom of the dielectric block 106 in the horizontal direction, but also passes through the dielectric block 106 in the vertical direction, so that the dielectric block 106 is formed by multiple sub-dielectric blocks that are spaced. The spaces between the sub-dielectric blocks may serve as the release holes 108. The multiple release holes 108 are defined in the inner space of the dielectric block 106, the outer space of the dielectric block 106, and defined above the spaces between the sub-dielectric blocks, speeding up the release of the sacrificial layer.

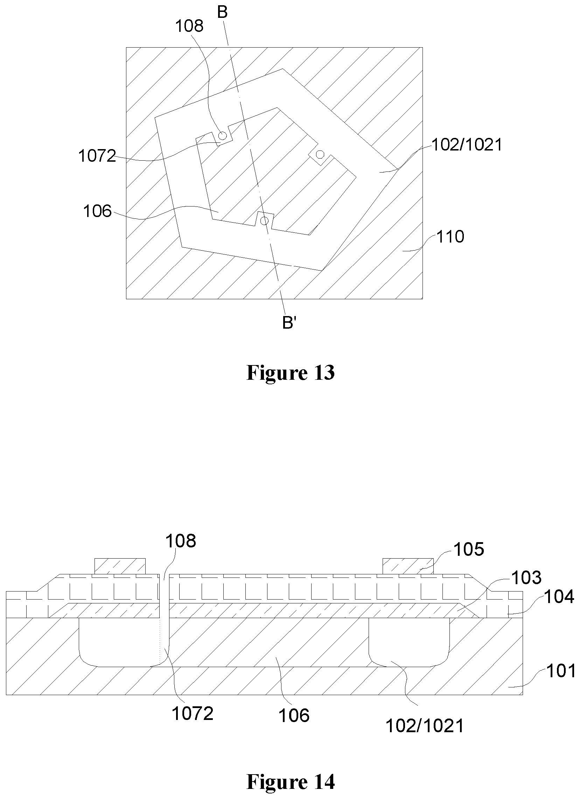

Figure 13 is a top view of an acoustic reflection structure of a resonator according to another embodiment of the present disclosure, and Figure 14 is a cross-sectional view of the resonator shown in Figure 13 along a BB' direction. As shown in Figures 13 and 14, the dielectric block 106 is solid, and a second release channel 1072 is defined on a side wall of the solid dielectric block 106. In the direction perpendicular to the substrate 101, the second release channel 1072 passes through the solid structure.

As shown in Figures 13 and 14, the acoustic reflection structure 102 is the cavity 1021, the cavity 1021 is the underground cavity, and the dielectric block 106 in the central of the cavity 1021 is solid. The cavity 1021 is a single annular cavity formed based on the dielectric block 106, and the second release channel 1072 extending towards a center of the dielectric block 106 is defined on a side wall of the dielectric block 106. The release hole 108 is defined in the functional layers above the second release channel 107. In the direction perpendicular to the substrate 101, the second release channel 1072 passes through the side wall of the dielectric block 106, so that the side wall of the dielectric block 106 is recessed. In this way, the release hole 108 passes through the functional layers can be in communication with the second release channel 1072. The solution or gas for releasing the sacrificial layer enters the second release channel 1072 through the release holes 108 and reacts with the sacrificial layer inside the cavity 1021 to remove the sacrificial layer and form the cavity 1021. The cavity 1021 is the single annular cavity, the piezoelectric layer 104 is film-shaped, and the first electrode 103 and the second electrode 105 are both annular as an example for explanation. A position where the cavity 1021 is located corresponds to a position where the second electrode 105 is located in the vertical direction, and the cavity 1021 is larger than the second electrode 105 in size. That is, the cavity 1021 is formed by proportionally enlarging the active region A1. In the direction perpendicular to the substrate 101, the dielectric block 106 may be in the same shape as or different shape from the cavity 1021. The second release channel 1072 and the release holes 108 inside the resonator not only improve the heat dissipation, but also greatly simplify a design for connecting different resonators, thereby minimizing a chip and improving the integration.

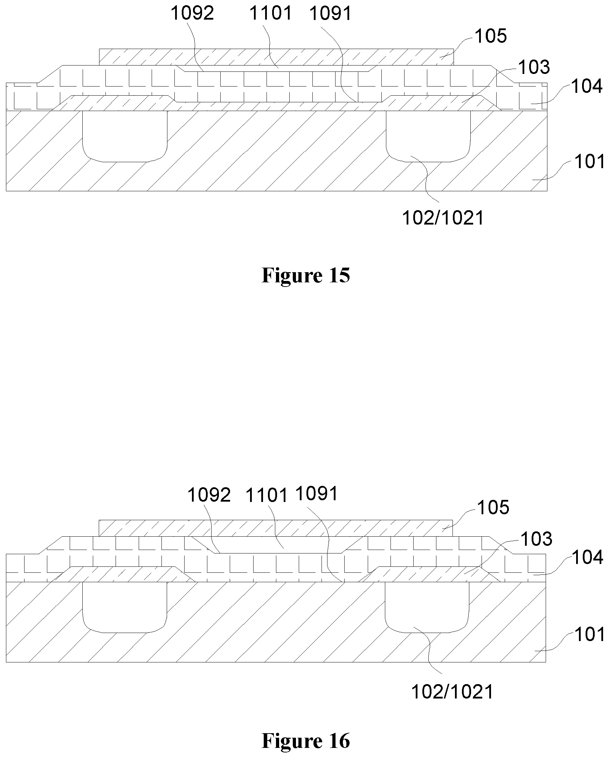

As shown in Figures 15 to 17, in another embodiment of the present disclosure, in the direction perpendicular to the substrate 101, a gap is provided between the piezoelectric layer 104 and the second electrode 105, and/or a gap is provided between the first electrode 103 and the piezoelectric layer 104. The gap is located in the inactive region A2, and the active region A1 is annular and surrounds the gap of the inactive region A2. In addition, in a region corresponding to the gap, a film layer above a region where the gap is located is not contact with a film layer below the region in the direction perpendicular to the substrate 101, so that the two film layers are isolated from each other, thereby weakening additional parasitic oscillation or avoiding the additional parasitic oscillation. In addition, one gap or two gaps may be provided between two of the substrate 101, the first electrode 103, the piezoelectric layer 104, and the second electrode 105 in the inactive region A2 of the resonator, which is not limited herein.

Figure 15 is a cross-sectional view of a resonator according to another embodiment of the present disclosure. As shown in Figure 15, at least one of an upper surface of the first electrode 103 and an upper surface of the piezoelectric layer 104 is provided with a first recessed part 1091, and a first gap 1101 is provided between at least one of the first recessed part 1091 and the second electrode 105.

As shown in Figure 15, the acoustic reflection structure 102 is annular and embedded inside the substrate 101. The upper surface of the first electrode 103 is provided with the first recessed part 1091. As the shape of the first recessed part 1091 changes, the piezoelectric layer 104 deposited on the first recessed part 1091 also changes to form a third recessed part 1092. The second electrode 105 is deposited on the piezoelectric layer 104 across the third recessed part 1092, and a first gap 1101 is formed between the third recessed part 1092 and the second electrode 105. In another embodiment, the first electrode 103 is film-shaped, and no recess formed in the upper surface of the first electrode 103. Instead, the first recessed part 1091 is directly formed on the piezoelectric layer 104 through etching or other manners. The second electrode 105 is deposited on the piezoelectric layer 104 across the first recessed part 1091, so that the first gap 1101 is formed between the first recessed part 1091 and the second electrode 105.

Figure 16 is a cross-sectional view of a resonator according to another embodiment of the present disclosure. As shown in Figure 16, in the embodiment of the present disclosure, the acoustic reflection structure 102 is annular and embedded inside the substrate 101. In the direction perpendicular to the substrate 101, the first gap 1101 is provided between the piezoelectric layer 104 and the second electrode 105. The first gap 1101 is formed as follows. A central region of the first electrode 103 is completely etched to form the first recessed part 1091, the surface of the substrate 101 is exposed, and the first electrode 103 is annular. The piezoelectric layer 104 is formed on the surface of the first electrode 103 and the exposed surface of the substrate 101, so that the third recessed part 1092 that corresponds to the exposed substrate 101 in position and shape is formed on the upper surface of the piezoelectric layer 104. The second electrode 105 is formed on the piezoelectric layer 104, and the second electrode 105 straddles the third recessed part 1092, so that the first gap 1101 is formed between the piezoelectric layer 104 and the second electrode 105. The gap is formed between the piezoelectric layer 104 and the second electrode 105 in the direction perpendicular to the substrate 101, and the first gap 1101 separates the second electrode 105 from the piezoelectric layer 104 in the direction perpendicular to the substrate 101, so that the second electrode 105 is not contact with the piezoelectric layer 104 in the direction perpendicular to the substrate 101, thereby avoiding the generation of the additional parasitic oscillation. In other embodiments, a gap may further be formed between the first electrode 103 and the piezoelectric layer 104. In such case, the central region of the first electrode 103 is partially or completely etched, so that a gap is formed between the first electrode 103 and the flat piezoelectric layer 104 above the first electrode 103. Alternatively, the first electrode 103 is etched to expose the surface of the substrate 101, and a gap is formed between the flat grown piezoelectric layer 104 and the exposed surface of the substrate 101.

The embodiments shown in Figures 15 and 16 are described with an example that the acoustic reflection structure 102 is embedded inside the substrate 101. In other embodiments, the acoustic reflection structure 102 is arranged above the surface of the substrate 101. In such case, the first gap 1101 is formed between the piezoelectric layer 104 and the second electrode 105 by partially or completely etching the central region of the first electrode 103, or by etching the central region of the piezoelectric layer 104. The acoustic reflection structure 102 may be the cavity 1021 or the Bragg reflection layer. Etching the first electrode 103 or etching the piezoelectric layer 104 may affects the piezoelectricity of the piezoelectric layer 104. Alternatively, both the first electrode 103 and the piezoelectric layer 104 are not etched or subjected to other processing, to improve the performance of the resonator.

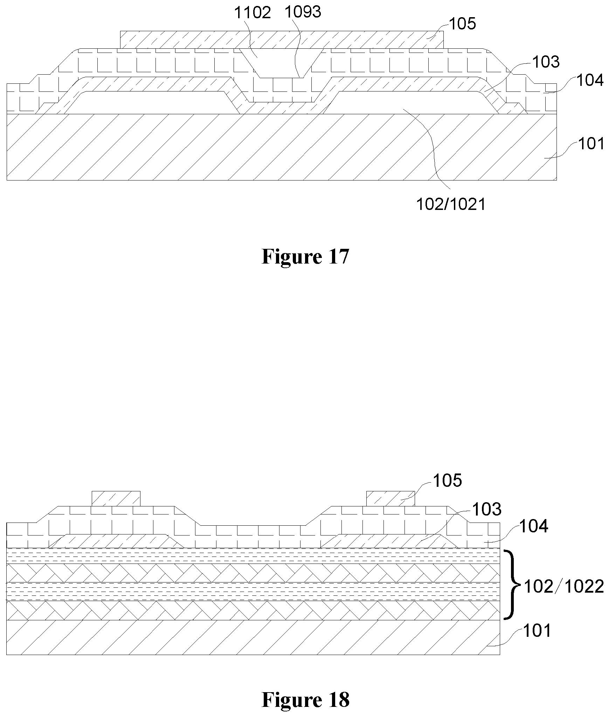

Figure 17 is a cross-sectional view of a resonator according to another embodiment of the present disclosure. As shown in Figure 17, in the embodiment, the first electrode 103 and the piezoelectric layer 104 are not etched or subjected to other processing, and the acoustic reflection structure 102 is arranged on the surface of the substrate 101 and arranged between the first electrode 103 and the substrate 101. The first electrode 103 is recessed downwards or the first electrode 103 and the piezoelectric layer 104 are recessed downwards, to form a second recessed part 1093. A second gap 1102 is provided between at least one of the second recessed part 1093 and the second electrode 105. The second gap 1102 is arranged in the inactive region A2. In other words, the first electrode 103 protrudes in the active region A1 and is recessed downwards in the inactive region A2 to form the second recessed part 1093, the piezoelectric layer 104 and the second electrode 105 are flat above the second recessed part 1093, so that the second gap 1102 is formed between the second recessed part 1093 of the first electrode 103 and the piezoelectric layer 104. Alternatively, the first electrode 103 protrudes in the active region A1 and is recessed downwards in the inactive region A2, the piezoelectric layer 104 is directly formed on the first electrode 103 and is recessed as the first electrode 103 being recessed, so that the second recessed part 1093 is formed on the piezoelectric layer 104. The second gap 1102 is formed between the second recessed part 1093 of the piezoelectric layer 104 and the flat second electrode 105. The acoustic reflection structure 102 is the cavity 1021. In the embodiment, in the direction perpendicular to the substrate 101, the second gap 1102 separates the piezoelectric layer 104 from the second electrode 105, so that the resonator does not generate additional parasitic oscillation at a region where the second gap 1102 is located. The above gap may be filled with air or a dielectric material, as long as the gap can avoid additional parasitic oscillation generated at the region.

Figure 18 is a cross-sectional view of a resonator according to another embodiment of the present disclosure. As shown in Figure 18, the embodiment of the present disclosure is described with an example that the acoustic reflection structure 102 is the Bragg reflection layer 1022. In the resonator according to the embodiment, the resonator includes the Bragg reflection layer 1022 arranged between the first electrode 103 and the substrate 101. The Bragg reflection layer 1022 may be arranged on the surface of the substrate 101. Alternatively, the substrate 101 is etched into a cavity, and the Bragg reflection layer 1022 is formed inside the cavity. In the direction perpendicular to the substrate 101, the Bragg reflection layer 1022 includes a film layer with high acoustic impedance and a film layer with low acoustic impedance that are arranged alternatively. Preferably, the Bragg reflection layer 1022 is directly formed on the surface of the substrate 101, and the substrate 101 is not etched or subjected to other processing, simplifying the production process.

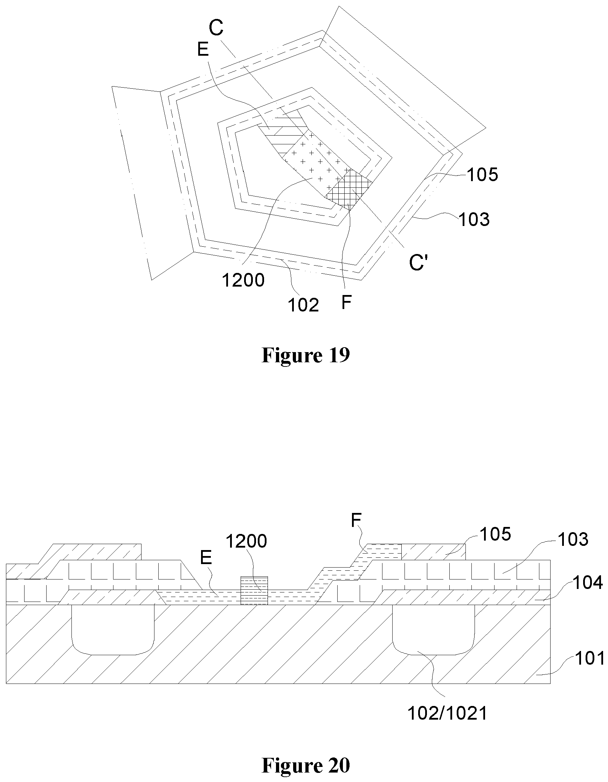

Figure 19 is a top view of a resonator assembly according to an embodiment of the present disclosure. As shown in Figure 19, based on the above resonator, a resonator assembly is provided according to an embodiment of the present disclosure. The bulk acoustic resonator is electrically connected to at least one electrical structure 1200. The electrical connection includes parallel connection or series connection. The at least one electrical structure 1200 is arranged in the inactive region A2, and the area of the inactive region A2 arranged inside the annular resonator is fully utilized to reduce the size of the resonator assembly.

In some embodiments, the bulk acoustic resonator is electrically connected to at least one electrical structure 1200 at the inactive region A2, and the electrical structure 1200 includes an electronic device or a circuit. The electronic device includes a capacitor, an inductor, or the like. The circuit includes an LC circuit or the like. The electrical structure 1200 is electrically connected to the active region A1, to regulate t a series resonance frequency Fs or a parallel resonance frequency Fp, greatly improving the flexibility of the active region A1. In a case that the electrical structure 1200 is the inductor, so that the parallel resonance frequency Fp of the active region A1 is shifted to right, increasing a bandwidth of a filter.

Figure 20 is a cross-sectional view of the resonator assembly illustrated in Figure 19 along a CC' direction. As shown in Figure 20, the first electrode 103 of the active region A1 is connected to one end of the electrical structure 1200 through a first connection part E, and the second electrode 105 of the active region A1 is connected to another end of the electrical structure 1200 through a second connection part F. The first connection part E may be made of the same material as or different material from the first electrode 103. The second connection part F may be made of the same material as or different material from the second electrode 105.

Therefore, based on the above resonator, a packaging structure is further provided according to the present disclosure, for packaging the above resonator.

The single resonator or a filter, a diplexer, a multiplexer, and other devices formed by cascaded resonators is to be packaged, to reduce the electromagnetic interference and environmental effect, and prolongate the operating lifetime. According to the conventional technology, packaging film technology is usually adopted. In a word, the packaging film technology is that a device is completely covered with a layer of film. In another packaging process, a main wafer bonds to a sub wafer, that is, an upper surface of the main wafer (including a circuit structure) is covered with the sub wafer, wires lead out the circuit, and copper pillars are made on the wires.

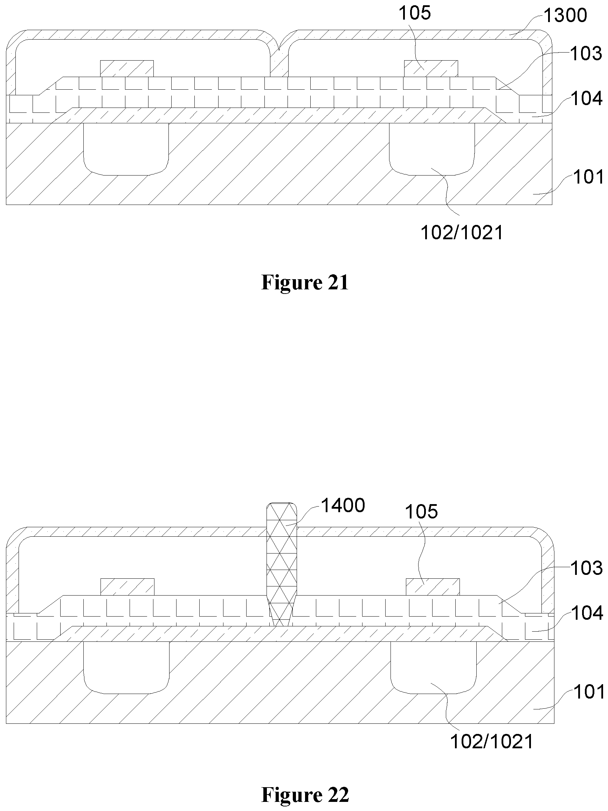

Figures 21 and 22 are cross-sectional views of a packaging structure for a resonator according to an embodiment of the present disclosure. Based on the above resonator, a packaging structure for a resonator is further provided according to another embodiment of present disclosure. A packaging film 1300 is arranged above any one of the bulk acoustic resonators described above. The packaging film 1300 seals the active region A1, and is acoustically isolated from the active region A1. That is, the packaging film 1300 is arranged on a side of the second electrode 105 away from the substrate 101, and is fixedly connected to a periphery of the piezoelectric layer 104 exposed around the second electrode 105, so as to package the resonator in such manner. The packaging structure for a single device is only provided according to the embodiment, and a packaging structure for the filter or the diplexer is similar as the packaging structure for a single device.

In order to increase the stability of the packaging film 1300 and prevent the packaging film 1300 from collapsing, the packaging film 1300 is directly connected to the inactive region A2, or a support part is provided between the packaging film 1300 and the inactive region A2. That is, the packaging film 1300 extends to the inactive region A2 and is directly connected to the inactive region A2. Alternatively, the support part is provided between the packaging film and the inactive region.

As shown in Figure 21, in the packaging structure according to the embodiment, the packaging film 1300 is directly connected to the inactive region A2, or the support part is provided between the packaging film 1300 and the inactive region A2. The packaging film 1300 extends from the outside of the resonator to the inactive region A2 of the resonator, and thence to the outside of the resonator, completely covering the resonator. The packaging film 1300 is directly connected to the inactive region A2 through bonding adhesive or other connection manner. The packaging structure for the filter formed by multiple resonators is that the packaging film 1300 extends from the outside of the multiple resonators to the inactive regions A2 of the multiple resonators, completely covering the filter. In addition to external support points, support points on the inactive regions A2 are added to support the packaging film 1300, effectively preventing the packaging film from collapsing and improving the reliability of a wafer level packaging (WLP) structure.

As shown in Figure 22, in the packaging structure, the support part includes a metal column 1400. A bottom of the metal column 1400 is electrically connected to the first electrode 103 or the second electrode 105, and a top of the metal column 1400 is exposed for electrical connection. The metal column 1400 is arranged in the inactive region A2. On the one hand, the metal column 1400 arranged in the inactive region A2 can facilitate heat dissipation. In a packaging structure without the metal column 1400, heat is dissipated from the lower surface of the substrate 101. When the resonator generates a large amount of heat, the heat is easily accumulated in the substrate 101. In the packaging structure with the metal column 1400 according to the embodiment, the heat generated by the resonator can be dissipated through both the substrate 101 and the metal column 1400. Moreover, the metal column 1400 also performs excellently in heat dissipation, and therefore the substrate 101 and the metal column 1400 greatly improve the heat dissipation of the resonator. On the other hand, the resonator with such metal column 1400 is small in size. In the conventional packaging structure without metal columns 1400, a metal structure for electrical connection is arranged on both sides of the packaging film 1300, and is configured to provide electrical connection for the resonator. The bottom of the metal column 1400 in the embodiment is electrically connected to the first electrode 103 or the second electrode 105. The top of the metal column 1400 is exposed to be electrically connected to an external power supply. Therefore, it is unnecessary to arrange a metal structure outside electrical connection, effectively reducing the resonator in size. Further, the difficulty of the process and the cost are also reduced, improving the yield of the resonator.

Based on the above embodiments, a filter is further provided according to an embodiment of the present disclosure. The filter includes the resonator according to any one of the above embodiments.

Based on the above embodiments, an electronic device is further provided according to an embodiment of the present disclosure. The electronic device includes the resonator according to any one of the above embodiments.

Based on the above embodiments, a method for fabricating a resonator is further provided according to another embodiment of the present disclosure.

A method for fabricating a bulk acoustic resonator is further provided according to another embodiment of the present disclosure. The method includes: providing a substrate 101; forming an acoustic reflection structure 102 on the substrate 101; and sequentially forming a first electrode 103, a piezoelectric layer 104, and a second electrode 105 on the substrate 101 and the acoustic reflection structure 102. In a direction perpendicular to the substrate, an overlapping region of the acoustic reflection structure 102, the first electrode 103, the piezoelectric layer 104, and the second electrode 105 is an active region A1, and the resonator has the annular active region A1. A distance from a point A on an inner edge of the active region to a center of the resonator is D, and the shortest distance from the point A to an outer edge of the active region A1 is W, where 0.1≤W/D≤10. Preferably, the substrate 101 is made of, e.g., Si, sapphire, or spinel. The acoustic reflection structure 102 includes a cavity 1021 or a Bragg reflection layer 1022. Preferably, the first electrode 103 is made of molybdenum (Mo). In another embodiment, the first electrode 103 is made of metal or alloy such as gold (Au), tungsten (W), copper (Cu), nickel (Ni), titanium (Ti), niobium (Nb), silver (Ag), tantalum (Ta), cobalt (Co), or aluminum (Al). Preferably, the piezoelectric layer 104 is made of aluminum nitride (AlN), or zinc oxide (ZnO), zinc sulfide (ZnS), lithium tantalate (LiTaO₃), cadmium sulfide (CdS), lead titanate (PbTiO₃), lead zirconate titanate (Pb (Zr, Ti) O₃), or the like. Preferably, the second electrode 105 is made of molybdenum (Mo). In another embodiment, the second electrode 105 is made of metal or alloy such as gold (Au), tungsten (W), copper (Cu), nickel (Ni), titanium (Ti), niobium (Nb), silver (Ag), tantalum (Ta), cobalt (Co), or aluminum (Al). The materials of the substrate 101, the first electrode 103, the second electrode 105, and the piezoelectric layer 104 include but are not limited to the above. In the direction perpendicular to the substrate 101, an inactive region A2 is arranged inside the annular active region A1. The annular active region A1 surrounds the inactive region A2.

Based on the embodiments of the present disclosure, the resonator, the resonator assembly, the filter, the electronic device, the method for fabricating the resonator, and the packaging structure are provided according to the present disclosure. The resonator has the annular active region A1, so that the resonator performs excellently in heat dissipation and thus basically remains at a constant temperature during operation. A distance from a point A on an inner edge of the active region A to a center of the resonator is D. The shortest distance from the point A to an outer edge of the active region A is W. The distance W is regulated based on the resonance frequency and the power tolerance for the resonator, so that the distance W and the distance D meet a condition of: 0.1≤W/D≤10, improving the heat dissipation and the power tolerance. In addition, the release channel and the release hole are defined on a central region of the substrate of the resonator for full use of space, thereby reducing the resonator in size. The height of the cavity is reduced, improving the heat dissipation, and reducing the deposition cost of the sacrificial layer. The first electrode 103 is etched, reducing a contact area between the first electrode 103 and the substrate 101, and therefore reducing the dielectric loss. The central region of the first electrode 103 is etched to form a gap between the first electrode 103 and the piezoelectric layer 104, so that the resonator does not generate resonance in the central region of the inactive region A2. Further, additional supports are provided on the inactive region A2 in the packaging structure for a resonator, significantly improving the reliability of the packaging structure, reducing the process difficulty, and improving the yield.

The embodiments in this specification are described in progressive, in parallel, or in a combination of progressive and parallel, each of which emphasizes the differences from others, and the same or similar parts among the embodiments can be referred to each other. The method, the resonator assembly, the filter and the electronic device according to the embodiments are described simply, as they correspond to the apparatus disclosed in the embodiments. Reference may be made to the description of the apparatus for relevant parts.

In the description of the present disclosure, it should be understood that the drawings and the description of the embodiments are illustrative rather than restrictive. The same reference numerals are used to identify the same structures throughout the embodiments of the specification. In addition, thicknesses of some layers, films, panels, or areas may be enlarged in the drawings for ease of understanding and description. It may be understood that, an element such as a layer, a film, an area or a substrate, when described as being "on" another element, may be directly or in directly on another element. In addition, the term "on" indicates to arrange an element on or below another element, and does not essentially indicate to arrange an element on top of another element in a direction of gravity.

The orientation or positional relationship indicated by the terms "upper", "lower", "top", "bottom", "inside", and "outside" and the like is based on the orientation or positional relationship shown in the drawings, and is merely for the convenience of describing the present disclosure or simplifying the description, instead of indicating or implying that the device or element must have a specific orientation or be constructed or operated in a specific orientation, and therefore cannot be understood as a limitation of the present disclosure. A component considered as being "connected" to another component may be directly or in directly connected to another component.

It should be further noted that the relationship terms herein such as "first", "second" and the like are merely used for distinguishing one entity or operation from another rather than necessitating or implying that any such actual relationship or order exists between entities or operations. Moreover, the terms "comprise", "include", or any other variants thereof are intended to be non-exclusive, such that the article, or device including a series of elements includes not only those elements but also elements that are not explicitly listed, or elements that are inherent in such article, or device. Unless explicitly limited, the statement "including a ..." does not exclude the case that other similar elements may exist in the article or device including the elements.

Based on the above description of the disclosed embodiments, those skilled in the art can implement or carry out the present disclosure. It is apparent that those skilled in the art may make many modifications to these embodiments. The general principle defined herein may be applied to other embodiments without departing from the spirit or scope of the present disclosure. Therefore, the present disclosure is not limited to the embodiments illustrated herein but has the widest scope that complies with the principle and novelty disclosed in the present disclosure.

## Claims

1. A bulk acoustic resonator, comprising:
a substrate;
a first electrode, wherein an acoustic reflection structure is arranged between the first electrode and the substrate;
a second electrode, wherein a piezoelectric layer is arranged between the second electrode and the first electrode, wherein
in a direction perpendicular to the substrate, an overlapping region of the acoustic reflection structure, the first electrode, the piezoelectric layer and the second electrode is an active region, and the active region is annular;
a distance from a point A on an inner edge of the active region to a center of the resonator is a D, and a shortest distance from the point A to an outer edge of the active region is W, wherein 0.1≤W/D≤10.

2. The bulk acoustic resonator according to claim 1, wherein an inactive region is arranged inside the inner edge of the active region, the active region is S 1 in area, and the inactive region is S2 in area, wherein S1 and S2 meet an equation of 0.2≤S1/S2≤12.

3. The bulk acoustic resonator according to claim 1, wherein shortest distances from a plurality of points A to the outer edge of the active region are a plurality of distances W, the plurality of distances W comprise a maximum and a minimum, and a ratio of the maximum to the minimum is 1.5:1.

4. The bulk acoustic resonator according to claim 1, wherein each of the distances W ranges from 10µm to 50µm.

5. The bulk acoustic resonator according to claim 1, wherein in the direction perpendicular to the substrate, at least one of the acoustic reflection structure, the piezoelectric layer, the first electrode, and the second electrode is annular, to form the active region that is annular.

6. The bulk acoustic resonator according to claim 1, wherein the acoustic reflection structure is arranged on an upper surface of the substrate or embedded inside the substrate.

7. The bulk acoustic resonator according to claim 1, wherein the acoustic reflection structure ranges from 0.1µm to 0.5µm in height.

8. The bulk acoustic resonator according to claim 2, wherein the acoustic reflection structure is provided with a dielectric block in a central region of the acoustic reflection structure, the dielectric block is arranged in the inactive region, and the acoustic reflection structure forms an annular structure based on the dielectric block.

9. The bulk acoustic resonator according to claim 8, wherein the dielectric block is in a hollow structure, a first release channel is defined on a bottom of the hollow structure, and the first release channel passes through the bottom of the hollow structure in the direction parallel to the substrate.

10. The bulk acoustic resonator according to claim 8, wherein the dielectric block is in a solid structure, a second release channel is defined on a side wall of the solid structure, and the second release channel passes through the solid structure in the direction perpendicular to the substrate.

11. The bulk acoustic resonator according to claim 2, wherein in the direction perpendicular to the substrate, a gap is provided between the piezoelectric layer and the second electrode, and/or a gap is formed between the first electrode and the piezoelectric layer, and the gap is located in the inactive region.

12. The bulk acoustic resonator according to claim 11, wherein at least one of an upper surface of the first electrode and an upper surface of the piezoelectric layer is provided with a first recessed part, and a first gap is formed between at least one of the first recessed part and the second electrode.

13. The bulk acoustic resonator according to claim 11, wherein the first electrode is recessed downwards or the first electrode and the piezoelectric layer are recessed downwards, to form a second recessed part, and a second gap is formed between at least one of the second recessed part and the second electrode.

14. A resonator assembly, comprising the bulk acoustic resonator according to any one of claims 1 to 13, wherein the bulk acoustic resonator is electrically connected to at least one electrical structure, and the at least one electrical structure is arranged in an inactive region.

15. A packaging structure for the bulk acoustic resonator according to any one of claims 1 to 13, wherein a packaging film is arranged above the resonator, the packaging film seals the active region, and the packaging film is acoustically isolated from the active region.

16. The packaging structure according to claim 15, wherein the packaging film is directly connected to the inactive region, or a support part is provided between the packaging film and the inactive region.

17. The packaging structure according to claim 16, wherein the support part comprises a metal column, a bottom of the metal column is electrically connected to the first electrode or the second electrode, and a top of the metal column is exposed for electrical connection.

18. A filter, comprising the resonator according to any one of claims 1 to 17.

19. An electronic device, comprising the resonator according to any one of claims 1 to 17.

20. A method for fabricating a bulk acoustic resonator, comprising:
providing a substrate;
forming an acoustic reflection structure on the substrate;
forming a first electrode, a piezoelectric layer, and a second electrode sequentially on the substrate and the acoustic reflection structure; wherein
in a direction perpendicular to the substrate, an overlapping region of the acoustic reflection structure, the first electrode, the piezoelectric layer and the second electrode is an active region, and the active region is annular;
a distance from a point A on an inner edge of the active region to a center of the resonator is D, and a shortest distance from the point A to an outer edge of the active region is W, wherein 0.1≤W/D≤10.
